# EUROPEAN PATENT APPLICATION

(11) **EP 4 753 441 A1**
(43) Date of publication of application: **03.06.2026**
(21) Application number: 25215006.5
(22) Date of filing: 11.11.2025
(51) Int. Cl.: H10W 90/20, H10W 90/28

(54) **GICL PACKAGE STRUCTURE WITH IMPROVED COMMUNICATION**

(30) Priority: 29.11.2024 CN 202411745115
(71) Applicant: NXP USA, Inc., Austin, TX 78735 (US)
(72) Inventor: Shah, Ankur Shailesh, 5656AG Eindhoven (NL); Carpenter, Burton Jesse, 5656AG Eindhoven (NL); Brauchler, Fred T, 5656AG Eindhoven (NL)
(74) Representative: Colaiuda, Antonella

(57) **Abstract**

Aspects of the subject disclosure may include, for example, a packaged integrated circuit device that includes two galvanically isolated integrated circuit die. The integrated circuit die include conductive coils that can be inductively coupled for wireless communications between the two galvanically isolated integrated circuit die. One of the integrated circuit die is flip chip mounted to the other integrated circuit die with the coils facing each other across an insulating layer that includes routing to provide power to the flip chip mounted integrated circuit die. Other embodiments are disclosed.

## Description

### FIELD OF THE DISCLOSURE

The subject disclosure relates to integrated circuit package structures.

### BACKGROUND

Galvanically isolated integrated circuits may communicate wirelessly. For example, two galvanically isolated integrated circuit die may each have conductive coils that can be used to communicate through inductive coupling.

### SUMMARY

In an example embodiment, a system includes a first integrated circuit die with a first communication coil, and a second integrated circuit die with a second communication coil. The second integrated circuit die is positioned with respect to the first integrated circuit die such that the first communication coil faces, and is aligned with, the second communication coil to allow inductive coupling between the first communication coil and the second communication coil. An insulating layer is positioned between the first integrated circuit die and the second integrated circuit die, and the insulating layer includes a first conductive trace coupled to provide an electrical connection (e.g., signals, and/or power) to the second integrated circuit die.

Additional example embodiments of the system include the insulating layer having a polymer layer formed on the first integrated circuit die, where the first conductive trace includes a wire bond pad area. Further, the insulating layer may be formed by an interposer circuit board. The insulating layer may also include a second conductive trace coupled to provide a second electrical connection (e.g., signals, and/or power) to the first integrated circuit die. The first conductive trace and the second conductive trace may be in separate voltage domains, and the insulating layer can provide galvanic isolation between the first integrated circuit die and the second integrated circuit die. Additionally, the insulating layer may leave an exposed portion of the first integrated circuit die, and a power connection to the first integrated circuit die may be formed on the exposed portion of the first integrated circuit die. The system may further include a dielectric underfill layer between the second integrated circuit die and the insulating layer, and the first integrated circuit die may include at least a third communication coil and the second integrated circuit die may include at least a fourth communication coil.

In another example embodiment, a packaged integrated circuit device includes a first integrated circuit die having a first conductive coil, and a first bond pad to provide a first electrical connection (e.g., signals and/or power) to the first integrated circuit die; a dielectric layer formed on the first integrated circuit die over the first conductive coil and the first bond pad, the dielectric layer including a via to provide electrical coupling to the first bond pad on the first integrated circuit die and a first conductive trace coupled to the via to provide the first electrical connection to the first integrated circuit die, the dielectric layer further including a second conductive trace; and a second integrated circuit die having a second conductive coil for inductive coupling to the first conductive coil, and a second bond pad to provide a second electrical connection to the second integrated circuit die, wherein the second integrated circuit die is mounted to the first integrated circuit die with the first conductive coil facing and aligned with the second conductive coil, and with the second bond pad facing and aligned with the second conductive trace on the dielectric layer to electrically couple the second conductive trace on the dielectric layer to the second bond pad to provide the second electrical connection to the second integrated circuit die.

Additional example embodiments of the packaged integrated circuit device may include the dielectric layer comprising a polymer layer, a redistribution layer, an interposer circuit board, or the like. Additionally, the dielectric layer may provide galvanic isolation between the first integrated circuit die and the second integrated circuit die, where the first bond pad and the second bond pad are galvanically isolated from each other.

In another example embodiment, a method, may include forming a first conductive coil on a first integrated circuit die; forming an insulating layer on the first integrated circuit die; forming a conductive trace on the insulating layer; forming a second conductive coil on a second integrated circuit die; placing a bond pad on the second integrated circuit die; and coupling the second integrated circuit die to the first integrated circuit die such that the second conductive coil faces, and aligns with, the first conductive coil to allow inductive coupling between the first conductive coil and the second conductive coil, and such that the bond pad on the second integrated circuit die couples to the conductive trace on the insulating layer to provide an electrical connection (e.g., signals and/or power) to the second integrated circuit die.

Additional example embodiments of the method include wherein the forming the insulating layer on the first integrated circuit die comprises forming a polyimide layer on the first integrated circuit die, wherein the forming the conductive trace on the insulating layer comprises forming a metallization layer on the polyimide layer, and wherein the electrical connection to the second integrated circuit die is configured to route power to the second integrated circuit die. Additionally, the method may include performing a solder reflow operation to couple the second integrated circuit die to the first integrated circuit die and filling a cavity between the second integrated circuit die and the insulating layer with a non-conductive underfill material.

### BRIEF DESCRIPTION OF THE DRAWINGS

The present disclosure is illustrated by way of examples, embodiments, and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIGs. 1 and 2 are cross-sectional illustrations of packaged electronic devices that include two galvanically isolated integrated circuit devices;
FIG. 3 shows an example process flow in accordance with various embodiments;
FIG. 4 is a flowchart representing example methods in accordance with various embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

It will be appreciated that the steps of various processes described herein are nonlimiting examples of suitable processes according to embodiments and are for the purposes of illustration. Systems and devices according to embodiments herein may be use any suitable processes including those that omit steps described above, perform those steps and similar steps in different orders, and the like. It will also be appreciated that well-known features may be omitted for clarity.

Unless explicitly stated otherwise, the use of terms "approximately," "substantially" and similar terms in connection with dimensions, relative positioning, or orientation of various features indicates that the dimensions, positioning, or orientation of those features are subject to tolerances and/or expected process variations of equipment and processes chosen to form the described features. Unless explicitly stated otherwise, the use of terms "approximately," "substantially" and similar terms in connection with measurable values or characteristics is subject to the expected measurement accuracy of equipment and methods used to measure those values or characteristics and/or within tolerance limits specified by technical standards applicable to the technologies described.

Communication between galvanically isolated integrated circuit die can be achieved by inductively coupling conductive communication coils in the integrated circuit die. This type of communication is referred to herein as Galvanically Isolated Communication Links (GICL). The size of the coils (and/or an amount of signal power) used for GICL may be influenced by the distance between the coils. For example, for a given signal power, a larger distance between inductively coupled coils will result in larger coils, which in turn may cause increases in overall integrated circuit die sizes.

Various embodiments described herein improve signal transfer by reducing distance between coils in integrated circuit die while maintaining galvanic isolation thereby allowing the reduction of coil size and potentially reducing integrated circuit die area. An integrated circuit die is mounted as a flip chip die on a separate integrated circuit die that has a high voltage isolation layer acting as insulation as well as a routing layer for wire bond connections. In some embodiments, the isolation layer may be a passivation layer with a redistribution layer (RDL), and in other embodiments, the isolation layer may be an interposer circuit board with a routing layer. In still further embodiments, the isolation layer may include conductive trace(s) used to route signals and power to the flip chip mounted integrated circuit die. These and other embodiments are further described below.

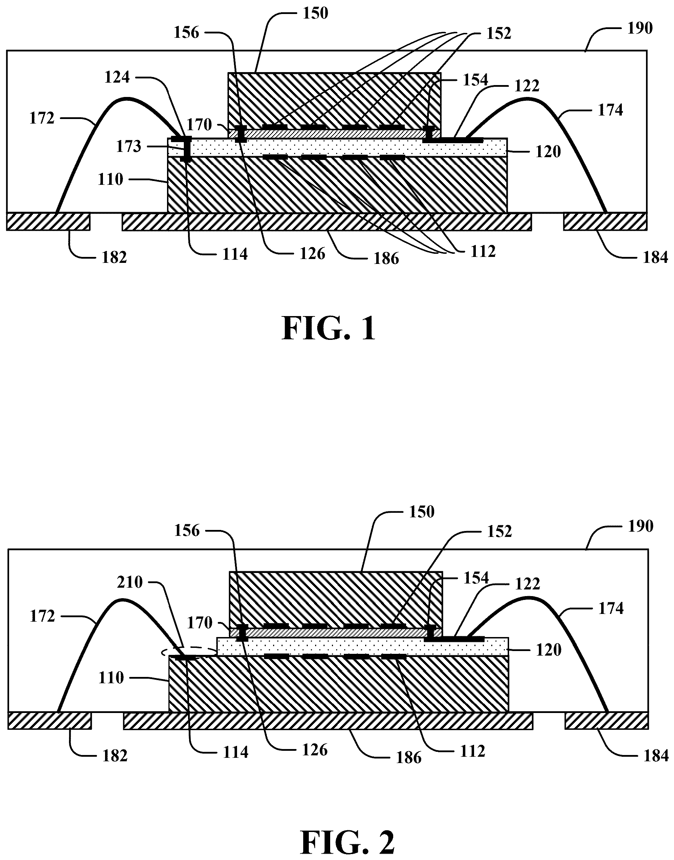

FIG. 1 is a cross-sectional illustration of a packaged electronic device that includes two galvanically isolated integrated circuit devices. The packaged electronic device of FIG. 1 includes a first integrated circuit die 110 and a second integrated circuit die 150 separated by an insulating layer 120. In some embodiments, the insulating layer 120 has a high voltage breakdown characteristic (e.g., >5000 Volts) such that the two integrated circuit die can operate in different voltage domains and can withstand large voltage transients without damaging either integrated circuit die. As an example, and not by way of limitation, one integrated circuit die may include digital control circuitry operating at a relatively low voltage (e.g., less than 10 Volts), and the second integrated circuit die may include high voltage circuitry (e.g., operating at hundreds of Volts) intended to drive an inverter or a motor (e.g., for an electric vehicle).

As shown in FIG. 1, the first integrated circuit die 110 is mounted to a lead frame segment 186. The first integrated circuit die 110 includes one or more conductive coils 112 and at least one bond pad 114 formed thereon. In some embodiments, the conductive coil(s) 112 and bond pad 114 are formed on one or more metallization layer(s) on the first integrated circuit die 110. In the example of FIG.1, the bond pad 114 provides power to the first integrated circuit die 110. In some embodiments, the bond pad 114 may provide a signal connection to the first integrated circuit die 110. Bond pads formed on integrated circuit die 110 may be used for any combination of signal connections and power connections. Four conductive coils 112 are shown on integrated circuit die 110; however, any number of conductive coils may be included. Similarly, one bond pad 114 is shown on integrated circuit die 110; however, any number of bond pads may be included.

Insulating layer 120 may include any material (at any thickness) that provides the desired amount of dielectric insulation qualities (e.g., >5000V breakdown characteristic). For example, a passivation layer (e.g., a polymer such as polyimide) may be formed on integrated circuit die 110 at a thickness that provides the desired characteristics. Also for example, an interposer circuit board may serve as insulating layer 120. At least one conductive trace is formed on insulating layer 120. For example, conductive trace 122 is formed on insulating layer 120 to provide a bonding pad for providing an electrical connection to second integrated circuit die 150. In the example of FIG. 1, wire 174 is wire bonded to conductive trace 122 and lead frame segment 184. Also for example, in some embodiments, conductive trace 124 is formed on insulating layer 120 along with via 173 to provide a wire bonding pad for routing power to integrated circuit die 110. In the example of FIG. 1, wire 172 is wire bonded to conductive trace 124 and lead frame segment 182. Also for example, conductive trace 126 is formed on insulating layer 120.

The second integrated circuit die 150 includes one or more conductive coils 152 and at least one bond pad 154, 156 formed thereon. In some embodiments, the conductive coil(s) 152 and bond pads 154, 156 are formed on a metallization layer on the second integrated circuit die 150. In the example of FIG.1, the bond pads 154 156 may provide signal and power connections to the second integrated circuit die 150. For example, bond pad 154 may provide power to the second integrated circuit die 150 and the bond pad 156 may provide other signal routing for integrated circuit die 150. Four conductive coils 152 are shown on integrated circuit die 150; however, any number of conductive coils may be included. Similarly, two bond pads 154, 156 are shown on integrated circuit die 150; however, any number of bond pads may be included.

Second integrated circuit die 150 is flip chip mounted to insulating layer 120 in a manner that substantially vertically aligns conductive coil(s) 152 with conductive coil(s) 112. In some embodiments, this is performed using a solder reflow operation. In embodiments represented by FIG. 1, the distance between inductively coupled conductive coils 152 and 112 is reduced as compared to an implementation in which second integrated circuit die 150 is mounted "upright" with conductive coil(s) 152 on top. If the second integrated circuit die 150 were to be mounted upright, the thickness of integrated circuit die 150 would be included in the distance between the conductive coils 152 and 112, thereby increasing the distance between the inductively coupled conductive coils. In the various flip chip embodiments described herein, the inductively coupled conductive coils are brought closer together, potentially allowing for lower signal power, smaller conductive coils, smaller integrated circuit die, or any combination thereof.

The packaged integrated circuit device shown in FIG. 1 also includes underfill material 170 and molding material 190. These materials may include any suitable non-conductive material.

In embodiments represented by FIG. 1, insulating layer 120 includes conductive traces that provide wire bonding pads to route electrical connections (e.g., signals and/or power) to both integrated circuit die 110, 150. For example, in some embodiments, conductive trace 122 may be electrically coupled to bond pad 154 to provide power to integrated circuit die 150 when power is applied to lead frame segment 184. Similarly, conductive trace 124 may be electrically coupled to bond pad 114 to provide power to integrated circuit die 110 when power is applied to lead frame segment 182.

FIG. 2 is a cross-sectional illustration of a packaged electronic device that includes two galvanically isolated integrated circuit devices. In embodiments represented by FIG. 2, insulating layer 120 leaves an exposed portion of the integrated circuit die 110. The exposed portion 210 occupies an area of integrated circuit die 110 that includes bond pad 114. Accordingly, in embodiments represented by FIG. 2, insulating layer 120 provides a conductive trace 122 to provide an electrical connection (e.g., to route a signal or to route power) to integrated circuit die 150 but does not provide an electrical connection (e.g., to route a signal or to route power) to integrated circuit die 110. In these embodiments, insulating layer 120 provides galvanic isolation between integrated circuit die 110 and 150 while only routing signal(s) and/or power to one of the integrated circuit die.

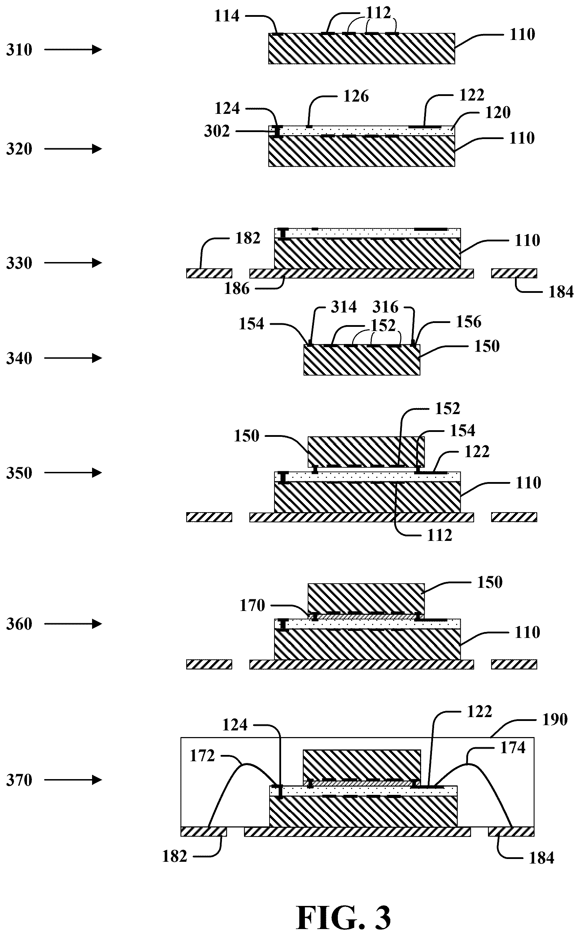

FIG. 3 shows an example process flow in accordance with various embodiments. At 310, conductive coil(s) 112 and bond pad 114 are formed on an integrated circuit die 110. In some embodiments, conductive coil(s) 112 are electrically coupled to wireless communication circuits within integrated circuit die 110. For example, one or more of conductive coil(s) 112 may be coupled to transmitter circuits, receiver circuits, transceiver circuits, or the like. In some embodiments, bond pad 114 may be electrically coupled to one or more circuits nodes within integrated circuit die 110 that supply power to circuits within integrated circuit die 110. In these embodiments, when a voltage is applied to bond pad 114, power may be supplied to circuits within integrated circuit die 110 such as control circuits, transmitter circuits, receiver circuits, transceiver circuits, or the like.

At 320, an insulating layer is formed on integrated circuit die 110. In some embodiments, a polymer layer is formed on integrated circuit die 110 to form insulating layer 120. In other embodiments, an interposer circuit board is attached to integrated circuit die 110 to form insulating layer 120. A via 302 is formed in insulating layer 120, and conductive traces 124, 122, and 126 are formed on insulating layer 120. As shown at 320, conductive trace 124 on insulating layer 120 is electrically coupled to bond pad 114 on integrated circuit die 110 to provide an electrical connection between conductive trace 124 and integrated circuit die 110. In embodiments in which bond pad 114 routes power to circuits within integrated circuit die 110, a voltage applied to conductive trace 124 on insulating layer 120 will provide power to integrated circuit device 110. Conductive trace 122 is electrically isolated from conductive trace 124.

In some embodiments, insulating layer 120 is made of a dielectric material that is thick enough to provide a desired minimum voltage breakdown characteristic (e.g., >5000V). For example, insulating layer 120 may be formed by a polyimide layer with a desired thickness (e.g., ~20um). Also for example, insulating layer may be formed by an interposer circuit board made from an organic material of a desired thickness.

At 330, integrated circuit die 110 with insulating layer 120 is singulated and mounted on a lead frame that includes lead frame segments 182, 184, and 186. Lead frame segments 182, 184, and 186 are electrically isolated from each other. This allows lead frame segment 182 to provide power (or a signal) to integrated circuit die 110 and lead frame segment 184 to provide power (or a signal) to integrated circuit die 150 while maintaining galvanic isolation between the two integrated circuit die.

At 340, conductive coil(s) 152 and bond pads 154 and 156 are formed on a second integrated circuit die 150. In some embodiments, conductive coil(s) 152 are electrically coupled to wireless communication circuits within integrated circuit die 150. For example, one or more of communication coil(s) 152 may be coupled to transmitter circuits, receiver circuits, transceiver circuits, or the like. In some embodiments, bond pad 154 is electrically coupled to one or more circuits nodes within integrated circuit die 150 that supply power to circuits within integrated circuit die 150. In these embodiments, when a voltage is applied to bond pad 154, power may be supplied to circuits within integrated circuit die 150 such as control circuits, transmitter circuits, receiver circuits, transceiver circuits, or the like. Metallic contact 314 is formed on bond pad 154 and metallic contact 316 is formed on bond pad 156. In some embodiments, metallic contacts 314, 316 are copper bumps or copper balls placed on the respective bond pads.

At 350, integrated circuit die 150 is flip chip mounted to integrated circuit die 110. In some embodiments, electrical and mechanical mounting of integrated circuit die 110 is accomplished by a solder reflow process. As part of this process, communication coils 112 and 152 are aligned and facing each other such that they can be inductively coupled. Further, conductive trace 122 is electrically coupled to bond pad 154 to provide an electrical connection (e.g., to route power and/or a signal) from conductive trace 122 on insulating layer 120 to circuits within integrated circuit die 150.

At 360, a non-conductive underfill material 170 is placed between integrated circuit die 150 and insulating layer 120. At 370, wire 172 is wire bonded to conductive trace 124 and lead frame segment 182, wire 174 is wire bonded to conductive trace 122 and lead frame segment 184, and the entire device is over molded at 190.

The resulting packaged integrated circuit device shown at 370 includes a first integrated circuit die 110 having a first conductive coil 112, and a first bond pad 114 to provide a first electrical connection to the first integrated circuit die; a dielectric layer 120 formed on the first integrated circuit die 110 over the first conductive coil 112 and the first bond pad 114, the dielectric layer 120 including a via 302 to provide electrical coupling to the first bond pad 114 on the first integrated circuit die 110 and a first conductive trace 124 coupled to the via 302 to provide the first electrical connection to the first integrated circuit die 110, the dielectric layer 120 further including a second conductive trace 122; and a second integrated circuit die 150 having a second conductive coil 152 for inductive coupling to the first conductive coil 112, and a second bond pad 154 to provide a second electrical connection to the second integrated circuit die 150, wherein the second integrated circuit die 150 is mounted to the first integrated circuit die 110 with the first conductive coil 112 facing and aligned with the second conductive coil 152, and with the second bond pad 154 facing and aligned with the second conductive trace 122 on the dielectric layer 120 to electrically couple the second conductive trace 122 on the dielectric layer 120 to the second bond pad 154 to provide the second electrical connection to the second integrated circuit die 150.

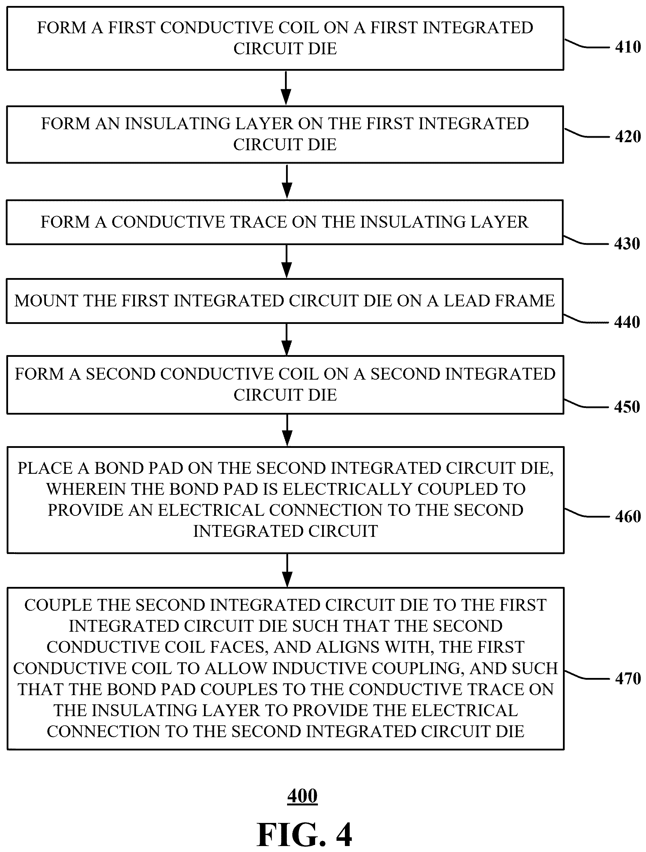

FIG. 4 is a flowchart representing example methods in accordance with various embodiments. At 410, a first conductive coil is formed on a first integrated circuit die. The first conductive coil may be a communication coil for use in inductive coupling to a coil in another integrated circuit die that is galvanically isolated from the first integrated circuit die. For example, the actions of 410 may form conductive coil(s) 112 on integrated circuit die 110.

At 420, an insulating layer is formed on the first integrated circuit die. In some embodiments, the insulating layer is a passivation layer formed from a polymer, and in other embodiments, the insulating layer is an interposer circuit board. The insulating layer may insulate the first integrated circuit die from a second integrated circuit die to provide galvanic isolation between the integrated circuit die while providing wireless communication between conductive coils in the integrated circuit die through inductive coupling. At 430, a conductive trace is formed on the insulating layer. The conductive trace may be one of many conductive traces formed in a metallization layer on the insulating layer. In some embodiments, at least one of the conductive traces routes signals and/or power to a second integrated circuit that is flip chip mounted to the first integrated circuit die.

At 440, the first integrated circuit die is mounted on a lead frame. In some embodiments, this includes mounting on a lead frame having electrically isolated lead frame segments. For example, the first integrated circuit die may be mounted on a first lead frame segment that is isolated from second and third lead frame segments (e.g., lead frame segments 182, 184).

At 450, a second conductive coil is formed on a second integrated circuit die. The second conductive coil may be a communication coil for use in inductive coupling to a communication coil on the first integrated circuit die. For example, the actions of 450 may form conductive coil(s) 152 on integrated circuit die 150.

At 460, a metallic contact is placed on the second integrated circuit die, wherein the metallic contact is electrically coupled to provide signals and/or power to the second integrated circuit. In some embodiments, the actions of 460 correspond to placing metallic contact 314 on bond pad 154.

At 470, the second integrated circuit die is coupled to the first integrated circuit die such that the second conductive coil faces, and aligns with, the first conductive coil to allow inductive coupling, and such that the metallic contact couples to the conductive trace on the insulating layer to provide an electrical connection (e.g., route a signal and/or power) to the second integrated circuit die.

## Claims

1. A system, comprising:
a first integrated circuit die with a first communication coil;
a second integrated circuit die with a second communication coil, wherein the second integrated circuit die is positioned with respect to the first integrated circuit die such that the first communication coil faces, and is aligned with, the second communication coil to allow inductive coupling between the first communication coil and the second communication coil; and
an insulating layer positioned between the first integrated circuit die and the second integrated circuit die, the insulating layer including a first conductive trace coupled to provide a first electrical connection to the second integrated circuit die.

2. The system of claim 1, wherein the insulating layer comprises a polymer layer formed on the first integrated circuit die, wherein the first conductive trace includes a wire bond pad area.

3. The system of claim 1 or claim 2, wherein the insulating layer comprises an interposer circuit board.

4. The system according to any preceding claim, wherein the insulating layer includes a second conductive trace coupled to provide a second electrical connection to the first integrated circuit die.

5. The system of claim 4, wherein the first conductive trace and the second conductive trace are in separate voltage domains, and the insulating layer provides galvanic isolation between the first integrated circuit die and the second integrated circuit die.

6. The system according to any preceding claim, wherein the insulating layer leaves an exposed portion of the first integrated circuit die, and a power connection to the first integrated circuit die is formed on the exposed portion of the first integrated circuit die.

7. The system according to any preceding claim, further comprising a dielectric underfill layer between the second integrated circuit die and the insulating layer.

8. The system according to any preceding claim, wherein the first integrated circuit die includes at least a third communication coil and the second integrated circuit die includes at least a fourth communication coil.

9. A packaged integrated circuit device comprising:
a first integrated circuit die having a first conductive coil, and a first bond pad to provide a first electrical connection to the first integrated circuit die;
a dielectric layer formed on the first integrated circuit die over the first conductive coil and the first bond pad, the dielectric layer including a via to provide electrical coupling to the first bond pad on the first integrated circuit die and a first conductive trace coupled to the via to provide the first electrical connection to the first integrated circuit die, the dielectric layer further including a second conductive trace; and
a second integrated circuit die having a second conductive coil for inductive coupling to the first conductive coil, and a second bond pad to provide a second electrical connection to the second integrated circuit die, wherein the second integrated circuit die is mounted to the first integrated circuit die with the first conductive coil facing and aligned with the second conductive coil, and with the second bond pad facing and aligned with the second conductive trace on the dielectric layer to electrically couple the second conductive trace on the dielectric layer to the second bond pad to provide the second electrical connection to the second integrated circuit die.

10. A method, comprising:
forming a first conductive coil on a first integrated circuit die;
forming an insulating layer on the first integrated circuit die;
forming a conductive trace on the insulating layer;
forming a second conductive coil on a second integrated circuit die;
placing a bond pad on the second integrated circuit die; and
coupling the second integrated circuit die to the first integrated circuit die such that the second conductive coil faces, and aligns with, the first conductive coil to allow inductive coupling between the first conductive coil and the second conductive coil, and such that the bond pad on the second integrated circuit die couples to the conductive trace on the insulating layer to provide an electrical connection to the second integrated circuit die.

11. The method of claim 10, wherein the forming the insulating layer on the first integrated circuit die comprises forming a polyimide layer on the first integrated circuit die.

12. The method of claim 10 or claim 11, wherein the forming the conductive trace on the insulating layer comprises forming a metallization layer on the polyimide layer.

13. The method according to claim 10 to 12, wherein the electrical connection to the second integrated circuit die is configured to route power to the second integrated circuit die.

14. The method according to claim 10 to 13, wherein coupling the second integrated circuit die to the first integrated circuit die comprises performing a solder reflow operation.

15. The method of claim 14, further comprising filling a cavity between the second integrated circuit die and the insulating layer with a non-conductive underfill material.
